# EUROPÄISCHE PATENTANMELDUNG

(11) **EP 4 418 503 A1**
(43) Veröffentlichungstag der Anmeldung: **21.08.2024**
(21) Anmeldenummer: 23157625.7
(22) Anmeldetag: 20.02.2023
(51) Int. Cl.: H02K 5/04, H02K 5/20

(54) **GEHÄUSE FÜR EINE ELEKTRISCHE BAUGRUPPE**

(71) Anmelder: BorgWarner Inc., Auburn Hills, MI 48326 (US)
(72) Erfinder: Brinkhaus, Roland, 55546 Volxheim (DE); Steingass, Patrick, 55232 Alzey (DE)
(74) Vertreter: Baur & Weber Patentanwälte PartG mbB

(57) **Zusammenfassung**

Gehäuse für eine elektrische Baugruppe mit einem metallenen Gehäusekörper (1), der einteilig ausgebildet ist oder mehrere Gehäuseteile umfasst und der wenigstens einen integrierten Kühlmittelanschluss (5) aufweist, wobei der Kühlmittelanschluss (5) als am Gehäusekörper (1) hervorstehender Stutzen ausgebildet ist und der Kühlmittelanschluss (5) einteilig mit dem Gehäusekörper (1) beziehungsweise mit einem der Gehäuseteile ausgebildet ist.

## Beschreibung

Die Erfindung betrifft ein Gehäuse für eine elektrische Baugruppe.

Elektromotoren werden in vielen Gebieten eingesetzt, beispielsweise für Fahrzeuge, insbesondere Elektroautos. Aber nicht nur zum Antrieb eines Fahrzeugs werden Elektromotoren eingesetzt, sondern auch in Ladern eines Fahrzeugs und/oder Gebläsen zum Kühlen. Bei einer Brennstoffzelle für ein Fahrzeug kann eine Laderanordnung mit einem elektroangetriebenen oder elektrounterstützten Verdichter für die Verdichtung der Luft vorgesehen sein, was eine Steigerung des Systemwirkungsgrads bewirkt. Ein elektroangetriebener oder unterstützter Lader kann auch bei Verbrennungsmotoren eingesetzt werden.

Ein Gehäuse für elektrische Baugruppen kann üblicherweise aus Kunststoff im Spritzgussverfahren gefertigt sein, um eine Wechselwirkung mit den elektrischen Komponenten im Inneren des Gehäuses zu verhindern. Ebenso kann das Gehäuse auch aus einem metallischen Werkstoff, beispielsweise zur Abschirmung, hergestellt werden.

Im Gehäuse des Elektromotors ist zur Kühlung von Motorkomponenten ein Kühlsystem vorgesehen, bei dem flüssiges Kühlmittel in einem Kühlkanal im Gehäuse die zu kühlenden Komponenten umströmt. Diese können rotierende oder stromdurchflossene Komponenten sein, bei denen im Betrieb Wärmeentwicklung auftritt. Als Schnittstelle zur Zuführung des Kühlmittels sind Kühlmittelanschlüsse am Gehäuse vorgesehen, durch die das Kühlmittel in das und aus dem Kühlmittelsystem strömt.

Bei einem konventionellen Gehäuse sind die Kühlmittelanschlüsse als separate Anschlusseinheiten ausgebildet, die in Aussparungen des Gehäuses angeordnet sind. Die Anschlusseinheiten können in das Gehäuse geschraubt, gepresst, gelötet oder geschweißt sein. Es gibt Ausführungen, bei denen zusätzlich Dichtelemente vorgesehen sind, damit die Verbindung zwischen dem Gehäuse und der Anschlusseinheit dicht ist.

Es stellt sich die Aufgabe, ein Gehäuse mit verbesserten Kühlmittelanschlüssen bereitzustellen.

Die Aufgabe wird durch ein Gehäuse eine elektrische Baugruppe mit den Merkmalen des Anspruchs 1 gelöst.

Das Gehäuse ist vorgesehen mit einem metallenen Gehäusekörper, der einteilig ausgebildet ist oder mehrere Gehäuseteile umfasst und der wenigstens einen integrierten Kühlmittelanschluss aufweist, wobei der Kühlmittelanschluss als am Gehäusekörper hervorstehender Stutzen ausgebildet ist und der Kühlmittelanschluss einteilig mit dem Gehäusekörper beziehungsweise mit einem der Gehäuseteile ausgebildet ist.

Der Gehäusekörper ist der wesentliche Gehäuseteil und umgibt als feste Hülle die Komponenten im Inneren des Gehäusekörpers. Er schützt die Komponenten im Inneren des Gehäuses. Der Gehäusekörper kann einteilig oder aus mehreren Gehäuseteilen, die zum Gehäusekörper zusammengefügt sind, ausgebildet sein.

Die elektrische Baugruppe umfasst elektrische, insbesondere elektronische Komponenten. Die Baugruppe ist eine konstruktive und in der Regel auch funktionelle Einheit aus integrierten oder diskreten Bauelementen, die, beispielsweise auf einem Träger, elektrisch und mechanisch verbunden sind. Beispiele für eine Baugruppe sind eine Steuerschaltung oder ein Elektromotor. Ein weiteres Anwendungsbeispiel ist ein elektrischer Kühlmittelheizer für Kraftfahrzeuge.

Es können ein oder mehrere Kühlmittelanschlüsse vorgesehen sein. Am Kühlmittelanschluss ist die Kühlmittelzuführung anschließbar, durch die Kühlmittel von außen zum Gehäuse strömt. Der Kühlmittelanschluss ist als stutzenförmige Erhebung ausgebildet, die rohrförmig und innen hohl ist, um das Kühlmittel einoder auszuleiten. In einer Ausführung hat der Stutzen eine hohlzylindrische Grundform, die jedoch beim Übergang zum Gehäusekörper verbreitert sein kann und insbesondere außenseitige Oberflächenstrukturen, z. B. Rillen oder Rippen, aufweisen kann. Die Strukturen können ausgebildet sein, den Anschluss einer Kühlmittelzuführung am Kühlmittelanschluss zu ermöglichen oder zu erleichtern.

Anstatt separate Anschlusseinheiten als Kühlmittelanschlüsse und Dichtung wie bei einem konventionellen Gehäuse zu verwenden, wird der Kühlmittelanschluss mit dem Gehäusekörper oder dem Gehäuseteil integriert ausgebildet, das heißt, dass der Kühlmittelanschluss mit dem Gehäusekörper oder dem Gehäuseteil einteilig gefertigt ist.

Die einteilige Ausbildung von Gehäusekörper beziehungsweise dessen Gehäuseteil und Kühlmittelanschluss reduziert den Aufwand und bringt Kostenvorteile. Es sind weniger Einzelteile erforderlich, insbesondere sind keine separaten Anschlusseinheiten und keine Dichtungen dafür erforderlich. Es entfällt auch die Notwendigkeit, diese Komponenten für die Fertigung bereitzuhalten oder zu beschaffen. Damit entfällt auch der Herstellungsschritt, bei dem diese Komponenten mit dem Gehäusekörper zusammengesetzt werden müssten. Auch Fehler beim Zusammenbau, wie z. B. nicht sorgfältig ins Gehäuse eingesetzte oder angezogene Anschlusseinheiten, können nicht mehr auftreten.

Wegen der einteiligen Ausbildung ist keine zusätzliche Prüfung der Kühlmittelschnittstelle auf Dichtheit erforderlich. Das bearbeitete Gehäuse wird üblicherweise standardmäßig als Ganzes auf Dichtheit geprüft. Durch die Integration der Kühlmittelanschlüsse reduziert sich auch das Leckagerisiko, das heißt das Risiko, dass Kühlmittel auslaufen könnte, denn es gibt keine abzudichtende Verbindung oder Schnittstelle zwischen dem Kühlmittelanschluss und dem Gehäusekörper.

Ein weiterer Vorteil ist, dass keine Kontaktkorrosion in den Kühlmittelanschlussbereichen und dem benachbarten Gehäusekörper auftritt, da im Gegensatz zur Verwendung konventioneller separater Anschlusseinheiten nicht verschiedene Materialen der Anschlusseinheiten, der Dichtungen und des Gehäuses aufeinandertreffen, wie dies bei einer beispielhaften konventionellen Kombination aus stählernen Anschlusseinheiten, Kupferdichtungen und einem Aluminiumgehäuse möglich wäre. Der Gehäusekörper beziehungsweise das Gehäuseteil und der integrierte Kühlmittelanschluss sind vorteilhafterweise aus demselben Material gefertigt.

Im Inneren des Gehäuses ist vorteilhafterweise ein Kühlsystem vorgesehen, in das und aus dem flüssiges Kühlmittel, beispielsweise Wasser, durch die Kühlmittelanschlüsse im Gehäuse leitbar ist. Wenigstens ein Kühlkanal ist im Gehäusekörper vorgesehen. Der Kühlkanal ist ein Hohlraum, der mit dem Kühlmittelanschluss gekoppelt ist, sodass das Kühlmittel durch den Kühlmittelanschluss in den oder aus dem Kühlkanal strömen kann. Üblicherweise sind zumindest zwei Kühlmittelanschlüsse je Kühlkanal vorgesehen, von denen einer als Kühlmitteleinlass und der andere als Kühlmittelauslass für das durch den Kühlkanal strömende Kühlmittel dient.

In einer Ausführung kann der Gehäusekörper Aluminium oder Stahl umfassen, sodass das Gehäuse stabil beziehungsweise leicht ist. Magnesium ist auch ein geeignetes Material.

In einer Ausführung ist der einteilige Gehäusekörper oder das Gehäuseteil mit dem Kühlmittelanschluss als Gusskomponente, beispielsweise als Druckgusskomponente ausgebildet. Der Kühlmittelanschluss oder eine Erhebung, aus der der Kühlmittelanschluss durch Materialabtrag geformt wird, ist ein angegossener Bereich der einteilig gefertigten Gusskomponente. Üblicherweise wird die Form des Kühlmittelanschlusses durch Weiterbearbeitung aus der Erhebung durch Materialabtrag gebildet. Alternativ ist der einteilige Gehäusekörper oder das Gehäuseteil mit dem Kühlmittelanschluss als 3-D-Druck-Komponente ausgebildet. Bei solch einer Ausführung muss eine Weiterbearbeitung zur Formung des Kühlmittelanschluss aus einer Erhebung nicht erforderlich sein.

Die Weiterbearbeitung der Erhebung kann vorteilhafterweise maschinell, insbesondere spanabtragend erfolgen. Die Bearbeitung der Erhebung kann beispielsweise durch Drehen oder Fräsen mittels eines entsprechenden Werkzeugs, erfolgen, sodass der Kühlmittelanschluss durch die maschinelle Bearbeitung überdreht oder gefräst ausgebildet ist. Vorteilhafterweise ist der Kühlmittelanschluss so positioniert, dass er Werkzeugfreigang aufweist, um das Werkzeug an der Erhebung, aus der dann der Kühlmittelanschluss geformt wird, anzusetzen. Der Werkzeugfreigang ist ausreichender Raum um den Kühlmittelanschluss, sodass das Werkzeug zu seiner Fertigung angesetzt werden konnte. Somit ist an der Erhebung ausreichend Abstand zu Gehäusekörpererhebungen oder weiteren Erhebungen für Kühlmittelanschlüsse beziehungsweise bereits geformten Kühlmittelanschlüssen. Der Werkzeugfreigang ist vorteilhafterweise für die Ausbildung des Kühlmittelanschluss als überdrehter oder gefräster Kühlmittelanschluss dimensioniert.

Bei einer Ausführung mit mehreren integrierten Kühlmittelanschlüssen sind diese so auf dem Gehäusekörper platziert, dass sie jeweils Werkzeugfreigang für die Ausbildung des Kühlmittelanschluss als maschinell bearbeiteter, insbesondere überdrehter oder gefräster, Kühlmittelanschluss aufweisen und es bei der Fertigung nicht zu Kollisionen mit dem Gehäusekörper oder anderen Kühlmittelanschlüssen oder Erhebungen für Kühlmittelanschlüsse kommt. Eine 5-Achs-Station kann bei diesem Fertigungsschritt zum Einsatz kommen.

Das zuvor beschriebene Gehäuse kann in einem Elektromotor vorgesehen sein. In einer Ausführung ist das Gehäuse als Axialflussmaschinen-Gehäuse oder als Radialflussmaschinen-Gehäuse ausgebildet. Solche Maschinen können in Fahrzeugen, beispielsweise Elektroautos eingesetzt werden. Das Gehäuse kann auch für Elektromotoren in Ladern und/oder Gebläsen eines Fahrzeugs eingesetzt werden. Bei solchen Anwendungen können auch noch weitere funktionale Komponenten der Gesamtanordnung im Gehäuse integriert sein, beispielsweise Lager für eine vom Elektromotor angetriebene Welle, sodass das Gehäuse in manchen Anwendungen auch als Lagergehäuse bezeichnet werden kann. Eine Laderanordnung mit einem elektroangetriebenen oder elektrisch unterstützten Verdichter zum Verdichten von Luft kann beispielsweise in Zusammenhang mit Brennstoffzellen oder Verbrennungsmotoren verwendet werden. In solch einen Verdichter strömt der Luftstrom üblicherweise axial in den Verdichter.

Das Gehäuse kann alternativ für eine Ansteuervorrichtung für einen Elektromotor, insbesondere in einer Ladervorrichtung für eine Brennstoffzelle oder einen Verbrennermotor, vorgesehen sein. Die Laderanordnung weist einen Verdichter auf, der elektrisch und/oder turbinenangetrieben sein kann. Bei einem turbinenangetriebenen Verdichter treiben Abgase eine Turbine an, deren Rotation über eine Welle auf ein Verdichterrad im Verdichter übertragen wird. Der turbinenangetriebene Verdichter kann elektrisch unterstützt sein. Alternativ wird der Verdichter durch einen Elektromotor angetrieben, der das Verdichterrad in Rotation versetzt. Die Ansteuervorrichtung umfasst eine elektronische Baugruppe, um den Betrieb der Ladervorrichtung, insbesondere des Verdichterantriebs, zu steuern. In einer Ausführung umfasst die Ansteuervorrichtung einer Inverter, um den Betrieb des Elektromotors in der Ladervorrichtung anzusteuern. Das Gehäuse kann integral mit dem Gehäuse der Ladervorrichtung ausgebildet sein oder ein separates Gehäuse sein.

In einer weiteren Ausführung ist das Gehäuse von einem elektrischen Kühlmittelheizer für Kraftfahrzeuge umfasst. Solch ein Kühlmittelheizer kann beispielsweise Kühlwasser erwärmen.

Nachfolgend werden einige Ausführungsbeispiele anhand der Zeichnung näher erläutert. Es zeigen:
Figur 1 eine schematische dreidimensionale Darstellung eines Ausführungsbeispiels eines Elektromotors,
Figur 2 eine dreidimensionale Ausschnitt-Explosionsdarstellung eines Ausführungsbeispiels eines konventionellen Gehäuses für einen Elektromotor, das nicht unter den Anspruch 1 fällt, und
Figur 3 eine dreidimensionale Ausschnittdarstellung eines Ausführungsbeispiels eines Gehäuses für einen Elektromotor.

In den Figuren sind gleiche oder funktional gleichwirkende Komponenten mit den gleichen Bezugszeichen versehen.

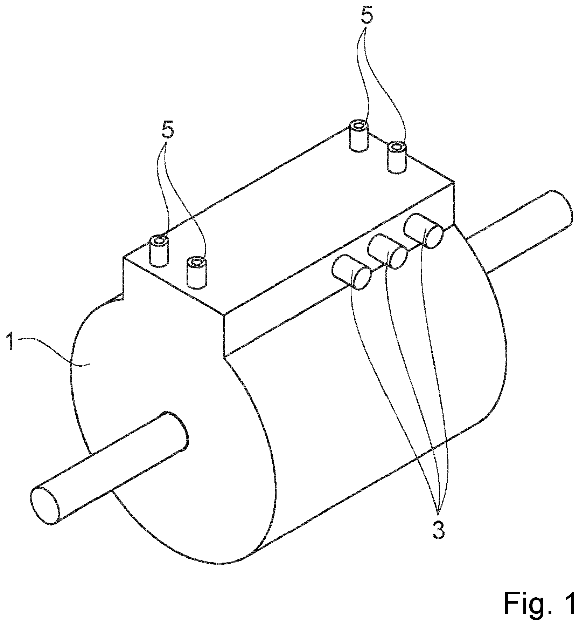

Figur 1 zeigt schematisch eine dreidimensionale Darstellung eines Ausführungsbeispiels eines Elektromotors. Das Gehäuse umfasst einen Gehäusekörper 1, Anschlüsse 3 für Versorgung und Steuerung sowie Kühlmittelanschlüsse 5 des Kühlsystems. Der Gehäusekörper 1 ist der wesentliche Gehäuseteil und umgibt als feste Hülle und Schutz die Komponenten im Inneren des Gehäusekörpers 1, sodass sie sowohl vor der Umgebung als auch vor Zugriff geschützt sind. Im Inneren des Gehäuses ist ein Kühlsystem vorgesehen, in das und aus dem flüssiges Kühlmittel, beispielsweise Wasser, durch die Kühlmittelanschlüsse 5 im Gehäuse leitbar ist. Der Gehäusekörper 1 kann einteilig oder aus mehreren Gehäuseteilen ausgebildet sein, beispielsweise mit verbundenen Stirn- und Mantelteilen. Die Kühlmittelanschlüsse 5 sind als am Gehäusekörper 1 hervorstehende Stutzen ausgebildet. Die Kühlmittelanschlüsse 5 sind einteilig mit dem Gehäusekörper 1 beziehungsweise mit einem der Gehäuseteile gefertigt.

Der Elektromotor kann beispielsweise als Axialflussmaschine oder Radialflussmaschine ausgebildet sein. Elektromotoren werden in vielen Gebieten eingesetzt, beispielsweise für Fahrzeuge, insbesondere Elektroautos. Aber nicht nur zum Antrieb eines Fahrzeugs werden Elektromotoren eingesetzt, sondern auch in Ladern und/oder Gebläsen, beispielsweise zum Kühlen, eines Fahrzeugs. Bei einer Brennstoffzelle für ein Fahrzeug kann eine Laderanordnung mit einem elektroangetriebenen oder elektrounterstützten Verdichter für die Verdichtung der Luft vorgesehen sein, um eine Steigerung des Systemwirkungsgrads zu bewirken. Ein elektroangetriebener oder unterstützter Lader kann auch bei Verbrennungsmotoren eingesetzt werden.

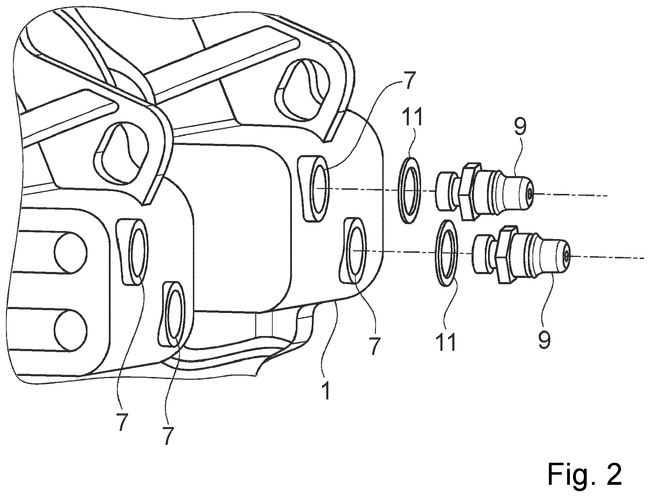

Figur 2 zeigt eine dreidimensionale Ausschnitt-Explosionsdarstellung eines Ausführungsbeispiels eines Elektromotor-Gehäuses mit konventionellen separaten Kühlmittelanschlüssen. An der Oberseite des metallenen Gehäusekörpers 1 sind Zugänge 7 des Kühlmittelsystems, die mit einem Kühlkanal im Inneren des Gehäusekörpers 1 verbunden sind. Die Zugänge 7 sind als Öffnungen im Gehäusekörper 1 ausgebildet. Um eine Schnittstelle zur Kühlmittelzuführung, die beispielsweise rohrförmig ausgebildet und in Figur 1 nicht dargestellt ist, auszubilden, sind in die Zugänge 7 separate Anschlusseinheiten 9 eingesetzt. In Figur 1 sind exemplarisch zwei Anschlusseinheiten 9 dargestellt. Es können weitere Anschlusseinheiten 9 vorgesehen sein. Zwischen den

Anschlusseinheiten 9 und den Zugängen 7 im Gehäusekörper 1 ist jeweils eine O-ringförmige Dichtung 11 vorgesehen. Die Anschlusseinheiten 9 können gedreht oder geschmiedet sein. Sie können mittels Schraubverbindung oder Pressverbindung mit dem Gehäusekörper 1 verbunden sein.

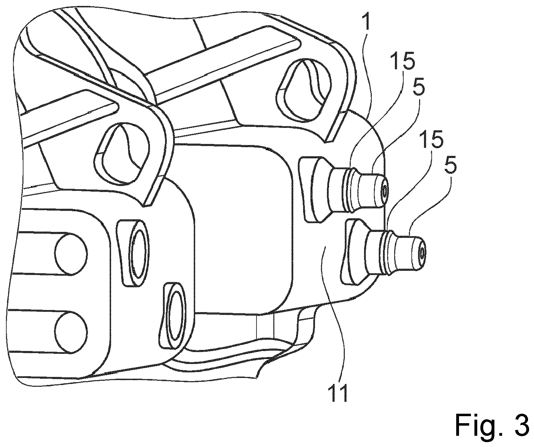

Figur 3 zeigt eine dreidimensionale Ausschnitt-Explosionsdarstellung eines Ausführungsbeispiels eines Elektromotor-Gehäuses mit integrierten Kühlmittelanschlüssen 5.

Das Gehäuse weist einen metallenen Gehäusekörper 1 auf, der den wesentlichen Teil des Gehäuses bildet, die funktionalen und drehenden Komponenten des Elektromotors schützt und umgibt und im Wesentlichen das Äußere des Elektromotors ausbildet. Der Gehäusekörper 1 kann mehrere Gehäuseteile umfassen, die zusammengesetzt sind. In dem Fall kann das Gehäuse noch Verbindungsmittel, beispielsweise Schrauben, und Dichtungen aufweisen.

Im Gegensatz zum vorherigen Ausführungsbeispiel sind die Kühlmittelanschlüsse 5 in diesem Ausführungsbeispiel einstückig mit dem Gehäuseteil gefertigt, an dem sie angeordnet sind, beziehungsweise einstückig mit dem einteiligen Gehäusekörper 1 gefertigt. In einem Ausführungsbeispiele sind nur integrierte Kühlmittelanschlüsse 5 vorgesehen. In einem alternativen Ausführungsbeispiel können integrierte Kühlmittelanschlüsse 5 und separate Anschlusseinheiten 9 für Zugänge 7 vorgesehen sein, wie in Figur 3 angedeutet.

Die Kühlmittelanschlüsse 5 ragen als Stutzen aus dem Gehäusekörper 1 und sind ausgebildet, mit einer Kühlmittelzuführung, die in Figur 3 nicht gezeigt ist, verbunden zu werden. Die Stutzen sind innen hohle, rohrförmige Erhebungen am Gehäusekörper 1. Die Kühlmittelzuführung, die mit dem Kühlmittelanschluss 5 verbunden wird, kann beispielsweise rohrförmig ausgebildet sein und führt das flüssige Kühlmittel zu den Komponenten des Elektromotors im Gehäuseinneren. Die Kühlmittelanschlüsse 5 sind als Stutzen mit hohlzylindrischer Grundform ausgebildet, wobei ein Fußbereich benachbart zum Gehäusekörper 1 in einem Ausführungsbeispiel konusförmig verbreitert sein kann. An der Außenseite können Kodierungen und/oder Rückhaltemittel für die Kühlmittelzuführung vorgesehen sein, die am Kühlmittelanschluss 5 befestigt werden soll. Solche Kodierungen und/oder Rückhaltemittel können beispielsweise Kerben oder Rippen oder umlaufende Gräben 15 auf der Außenseite sein.

Die Kühlmittelanschlüsse 5 werden zusammen mit dem Gehäuseteil oder dem Gehäusekörper 1 gefertigt, was zur einteiligen Ausbildung bereits während der Fertigung führt. In einem Ausführungsbeispiel wird das Gehäuseteil oder der Gehäusekörper 1 zusammen mit dem Kühlmittelanschluss 5 im selben Schritt gegossen oder 3-D-gedruckt. Wenn eine Weiterbearbeitung vorgesehen ist, um die Form der Kühlanschlüsse nach der Fertigung des Gehäusekörpers 1 oder der Gehäuseteile auszubilden, so werden der Gehäusekörper 1 oder die Gehäuseteile zusammen mit den für Kühlmittelanschlüsse 5 vorgesehenen Erhebungen ausgebildet. Aus den Erhebungen, die vorteilhafterweise bereits eine stutzenförmige Grundform haben, werden dann die Kühlmittelanschlüsse 5 in ihrer endgültigen Form gebildet.

Die Kühlmittelanschlüsse 5 oder die für Kühlmittelanschlüsse 5 vorgesehenen Erhebungen und der Gehäusekörper 1 oder das Gehäuseteil werden zusammen im selben Schritt gefertigt, beispielsweise durch Gießen oder 3-D-Drucken. Der Gehäusekörper 1 oder das Gehäuseteil kann als Gussteil, insbesondere als Druckgussteil, ausgebildet sein, bei dem die Kühlmittelanschlüsse 5 oder die für Kühlmittelanschlüsse 5 vorgesehenen Erhebungen angegossen sind. Alternativ kann der Gehäusekörper 1 oder das Gehäuseteil als 3-D-Druck-Komponente ausgebildet sein.

In einer Ausführung ist keine weitere Bearbeitung der Kühlmittelanschlüsse 5 nach dem zuvor beschriebenen Fertigungsschritt vorgesehen, dies betrifft insbesondere 3-Druck und Druckguss. Alternativ werden aus den für die Kühlmittelanschlüsse 5 vorgesehenen Erhebungen die Kühlmittelanschlüsse 5 geformt. Die für die Kühlmittelanschlüsse 5 vorgesehenen Erhebungen sind Basis der Kühlmittelanschlüsse 5 und sind vorteilhafterweise bereits hohlzylindrisch ausgebildet. Alternativ können die Löcher in den Erhebungen auch bei der Weiterbearbeitung ausgebildet werden. Die Erhebungen haben zumindest eine Bearbeitungszugabe, die bei der Weiterbearbeitung abgetragen wird, um vorteilhafterweise die Fertigungstoleranzen zu reduzieren, bis die Kühlmittelanschlüsse 5 die gewünschte Form haben. Die Form wird nach Kundenwunsch aus den zylindrischen Erhebungen herausgearbeitet. So ist es möglich, aus den gleichen Ausgangskörpern Gehäusekörper 1 oder Gehäuseteile mit verschiedenen Kühlmittelanschlüssen 5 zu formen.

Durch ein Material abtragendes Fertigungsverfahren erhalten die Kühlmittelanschlüsse 5 ihre endgültige Form. In einem Ausführungsbeispiel sind die Kühlmittelanschlüsse 5 überdreht. Dabei wird die Form der Kühlmittelanschlüsse 5 durch spanabtragendes Überdrehen von für Kühlmittelanschlüsse 5 vorgesehenen Erhebungen im Gehäusekörper 1 ausgebildet. Zu diesem Zweck wird ein Werkzeug zum Materialabtrag auf die Erhebungen aufgesetzt.

Wegen der Weiterbearbeitung ist die Erhebung für den Kühlmittelanschluss 5 und damit auch der daraus geformte Kühlmittelanschluss 5 so positioniert, dass die Erhebung beziehungsweise der Kühlmittelanschluss 5 einen Werkzeugfreigang 13 aufweist. Der Werkzeugfreigang 13 ist ein den Kühlmittelanschluss 5 umgebender Bereich, in dem keine Gehäusebereiche hinein- oder aufragen, die das Werkzeug behindern könnten. Der Kühlmittelmittelanschluss 5 ist für das Werkzeug zur Weiterbearbeitung zugänglich, sodass beispielsweise der Werkzeugkopf zum Überdrehen aufgesetzt werden kann. Bei mehreren integrierten Kühlmittelanschlüssen 5 sind diese so platziert sind, dass sie jeweils Werkzeugfreigang 15 aufweisen. Das Werkzeug zur Weiterbearbeitung wird weder durch die Form des Gehäusekörpers 1 behindert noch durch andere Kühlmittelanschlüsse 5 oder für die Kühlmittelanschlüsse 5 vorgesehenen Erhebungen.

In einem Ausführungsbeispiel eines Gehäuses ist darin eine Ansteuervorrichtung für eine Ladervorrichtung für eine Brennstoffzelle oder einen Verbrennermotor vorgesehen. Die Laderanordnung weist einen Verdichter auf, der elektrisch angetrieben sein kann oder dessen Turbinenantrieb elektrisch unterstützt sein kann. Solch eine Laderanordnung wird auch als E-Turbolader bezeichnet. Die Ansteuervorrichtung umfasst eine elektronische Baugruppe, um den Betrieb des Elektromotors für den Verdichterantrieb zu steuern. Vorteilhafterweise ist in der Ansteuervorrichtung ein Inverter vorgesehen, um den Betrieb des Elektromotors zu steuern.

In einem weiteren Ausführungsbeispiel ist das Gehäuse von einem elektrischen Kühlmittelheizer für Kraftfahrzeuge umfasst. Solch ein Kühlmittelheizer mit einer elektrischen Baugruppe für die Kühlmittelerwärmung steuert und deren Ansteuerung kann beispielsweise Kühlwasser erwärmen.

Die vorstehend und die in den Ansprüchen angegebenen sowie die den Abbildungen entnehmbaren Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens in mancherlei Weise abwandelbar.

### Bezugszeichen

- 1: Gehäusekörper
- 3: Anschluss
- 5: Kühlmittelanschluss
- 7: Zugang
- 9: Anschlusseinheit
- 11: Dichtung
- 13: Werkzeugfreigang
- 15: Graben

## Patentansprüche

1. Gehäuse für eine elektrische Baugruppe mit einem metallenen Gehäusekörper (1), der einteilig ausgebildet ist oder mehrere Gehäuseteile umfasst und der wenigstens einen integrierten Kühlmittelanschluss (5) aufweist, wobei der Kühlmittelanschluss (5) als am Gehäusekörper (1) hervorstehender Stutzen ausgebildet ist und der Kühlmittelanschluss (5) einteilig mit dem Gehäusekörper (1) beziehungsweise mit einem der Gehäuseteile ausgebildet ist.

2. Gehäuse nach Anspruch 1,
bei dem sich wenigstens ein Kühlmittelkanal im Gehäusekörper (1) erstreckt, der mit dem Kühlmittelanschluss (5) gekoppelt ist, sodass ein Kühlmittel durch den Kühlmittelanschluss (5) in den oder aus dem Kühlkanal strömen kann.

3. Gehäuse nach Anspruch 1 oder 2,
wobei der einteilige Gehäusekörper (1) oder das Gehäuseteil mit dem Kühlmittelanschluss (5) als Gusskomponente oder als 3-D-Druck-Komponente ausgebildet ist.

4. Gehäuse nach einem der vorherigen Ansprüche,
wobei der metallene Gehäusekörper (1) Aluminium, Magnesium oder Stahl umfasst.

5. Gehäuse nach einem der vorherigen Ansprüche,
wobei der Kühlmittelanschluss (5) maschinell bearbeitet ist.

6. Gehäuse nach einem der vorherigen Ansprüche
wobei der Kühlmittelanschluss (5) so positioniert ist, dass er Werkzeugfreigang (13) aufweist.

7. Gehäuse nach Anspruch 6,
wobei der Werkzeugfreigang (13) für die Ausbildung des Kühlmittelanschluss (5) als überdrehter oder gefräster Kühlmittelanschluss (5) dimensioniert ist.

8. Gehäuse nach Anspruch 6 oder 7,
das mehrere integrierte Kühlmittelanschlüsse (5) aufweist, die so auf dem Gehäusekörper (1) platziert sind, dass sie jeweils Werkzeugfreigang (13) für die Ausbildung des Kühlmittelanschluss (5) als maschinell bearbeiteter Kühlmittelanschluss (5) aufweisen.

9. Gehäuse nach einem der vorherigen Ansprüche,
das als Axialflussmaschinen-Gehäuse oder als Radialflussmaschinen-Gehäuse ausgebildet ist.

10. Elektromotor umfassend ein Gehäuse nach einem der vorherigen Ansprüche.

11. Ansteuervorrichtung für einen Elektromotor, insbesondere in einer Ladervorrichtung, umfassend ein Gehäuse nach einem der Ansprüche 1 bis 9.

12. Ansteuervorrichtung nach Anspruch 11, die einen Inverter umfasst.

13. Elektrischer Kühlmittelheizer für Kraftfahrzeuge umfassend ein Gehäuse nach einem der Ansprüche 1 bis 9.
